# EUROPÄISCHE PATENTSCHRIFT

(11) **EP 1 425 771 B1**
(45) Veröffentlichungstag und Bekanntmachung des Hinweises auf die Patenterteilung: **22.03.2006**
(21) Anmeldenummer: 02754495.6
(22) Anmeldetag: 07.08.2002
(51) Int. Cl.: H01H 85/32

(54) **SICHERUNGSBAUELEMENT MIT OPTISCHER ANZEIGE**
FUSE COMPONENT COMPRISING AN OPTICAL INDICATOR
COMPOSANT FUSIBLE A INDICATEUR OPTIQUE

(30) Priorität: 31.08.2001 DE 10142654
(43) Veröffentlichungstag der Anmeldung: 09.06.2004
(73) Patentinhaber: Osram Opto Semiconductors GmbH, 93049 Regensburg (DE)
(72) Erfinder: MÜLLER, Rüdiger, 93128 Regenstauf (DE)
(74) Vertreter: Epping - Hermann - Fischer
(86) Internationale Anmeldenummer: PCT/DE2002/002907
(87) Internationale Veröffentlichungsnummer: WO 2003/028060

(56) Entgegenhaltungen:
- EP-A- 1 003 194
- US-A- 4 350 407
- US-A- 4 499 447
- US-A- 4 511 875

## Beschreibung

Die Erfindung betrifft ein elektrisches Sicherungsbauelement mit optischer Anzeige nach dem Oberbegriff des Patentanspruchs 1.

Sicherungsbauelemente dieser Art weisen in der Regel einen Schmelzsteg auf, der so dimensioniert ist, daß bei Überschreiten eines Maximalstroms der Schmelzsteg durchschmilzt und damit den Stromfluß unterbricht. Üblicherweise ist der Schmelzsteg in ein Gehäuse eingebaut, so daß von außen ein Defekt des Schmelzstegs oftmals nur schlecht zu erkennen ist. Zudem wird die Erkennung eines solchen Defekts meist durch die geringen Abmessungen des Schmelzstegs erschwert.

Aus US 4,695,815 ist eine Kfz-Sicherung mit optischer Anzeige bekannt. Hier ist parallel zum Schmelzsteg eine Glühlampe geschaltet. Bei unterbrochenem Schmelzsteg leuchtet die Glühlampe auf und zeigt so den Defekt der Sicherung an. Weiterhin ist eine Kfz-Sicherung gezeigt, bei der die Glühlampe in einer Gehäuseausnehmung angeordnet ist.

Bei dieser Anordnung ist die Glühlampe von außen frei zugänglich, so daß die Gefahr einer Beschädigung durch äußere Einwirkung besteht. Ein zusätzlicher Schutz durch eine Umhüllung, beispielsweise eine Vergußmasse, erfordert zusätzlichen Aufwand, da sicherzustellen ist, daß die Vergußmasse thermisch und mechanisch an den Glaskolben der Glühlampe angepaßt ist. Weiterhin muß eine ausreichende Haftung zwischen Glaskolben und Vergußmasse bestehen und das Eindringen von Feuchtigkeit in die Sicherung verhindert werden.

Zudem sind Glühlampen vergleichsweise empfindliche Bauelemente, so daß nach längerem Einbau auch im unbeleuchteten Zustand die Gefahr eines Defekts der Glühlampe, beispielsweise durch Verlust des Unterdrucks im Glaskolben oder durch Abriß des Glühfadens, besteht. Ein solcher, wenn auch selten auftretender Defekt der Ausfallanzeige bei einer Sicherung ist besonders zu vermeiden, da sich der Anwender auf die optische Ausfallanzeige verläßt und daher eine durchgebrannte Sicherung mit defekter Ausfallanzeige nur sehr schwer auffindet.

In der EP 1 003 194 Al ist ebenfalls eine Sicherung für Automobile mit einer optischen Ausfallanzeige offenbart, wobei die Ausfallanzeige sowohl durch konventionelle Lampen als auch durch Leuchtdioden-Bauelemente oder sonstige Licht emittierende Bauelemente gebildet sein kann. Die Sicherung umfasst einen Sicherungsteil und ein Gehäuseteil, das über das Sicherungsteil gestülpt ist und von diesem abnehmbar ist. Das Sicherungteil hat einen Schmelzsteg und einen parallel zu diesem geschalteten Schaltkreis, wobei in dem Schaltkreis beispielsweise ein Leuchtdioden-Bauelement montiert ist.

Es ist Aufgabe der vorliegenden Erfindung, ein Sicherungsbauelement mit optischer Anzeige zu schaffen, das eine hohe Zuverlässigkeit aufweist. Weiterhin ist es Aufgabe der Erfindung, ein Sicherungsbauelement mit optischer Anzeige anzugeben, das zugleich kostengünstig und technisch einfach herzustellen ist.

Diese Aufgabe wird durch ein Sicherungsbauelement nach Patentanspruch 1 gelöst. Vorteilhafte Weiterbildungen der Erfindung sind Gegenstand abhängigen Ansprüche.

Erfindungsgemäß ist vorgesehen, daß das Sicherungsbauelement einen ersten und einen zweiten Anschluß aufweist und diese Anschlüsse über einen Schmelzsteg elektrisch leitend verbunden sind. Als optische Anzeige enthält das Sicherungsbauelement mindestens eine LED (Light emitting diode) in Form eines LED-Chips, der kathodenseitig mit dem ersten Anschluß und anodenseitig mit dem zweiten Anschluß verbunden ist. Unter einem LED-Bauelement ist ein optoelektronisches Bauelement, mit einem LED-Chips of der insbesondere in ein Gehäuse oder einem Montagekörper enthalten ist. Die Erfindung bezieht sich auf die Verwendung von LED-Chips. Bevorzugt ist des LED-Chip mit einem Strombegrenzungewiderstand in Serie geschaltet.

Eine LBD besitzt eine sehr große Lebensdauer und weist zudem eine hohe Ausfallsicherheit auf. Auch große Schwankungen der Umgebungstemperatur können toleriert werden. Schließlich können Sicherungen mit LEDs sehr kostengünstig hergestellt werden, wie im folgenden noch genauer ausgeführt wird.

Bei einer vorteilhaften Weiterbildung der Erfindung sind zwei LED-Chips jeweils zum Schmelzsteg parallel geschaltet, wobei die Durchflußrichtungen der LEDs einander entgegengesetzt sind. Dies hat den Vorteil, daß ein Ausfall der Sicherung unabhängig von der Polung der Sicherung angezeigt wird, da in jedem Fall eine der beiden LEDs in Durchlaßrichtung gepolt ist. Aufgrund der symmetrischen Schaltung der LEDs kann das Sicherungsbauelement wie eine herkömmliche Schmelzsicherung verwendet werden, ohne daß auf eine Polung zu achten wäre.

Vorzugsweise sind die Kontakte und der Schmelzsteg auf einem Leiterrahmen angeordnet oder als Teile eines Leiterrahmens gebildet. Des LED-Chips wird auf dem Leiterrahmen in an sich bekannter Weise angebracht. Technologien zur Herstellung von Leiterrahmen und zur Montage von LEDs hierauf sind bekannt und etabliert. Ein erfindungsgemäßes Sicherungsbauelements kann somit unter Verwendung bestehender Produktionsanlagen kostengünstig hergestellt werden.

Besonders bevorzugt weist der Leiterrahmen die Grundform eines Jochs auf, wobei die Jochschenkel die Anschlüsse des Sicherungsbauelement bilden. Der Schmelzsteg kann als Teil des Jochbalkens oder parallel zu dem Jochbalken gebildet sein. Je nach Ausführungsform ist dazu der Jochbalken unterbrochen oder im Querschnitt auf die erforderlichen Abmessungen des Schmelzstegs reduziert. Die jochartige Formgebung entspricht bei einer bevorzugten Ausführungsform im wesentlichen der Grundform einer herkömmlichen Kfz-Sicherung, so daß die Erfindung zu diesen Sicherungen kompatibel ist.

Bei einer vorteilhaften Ausgestaltung der Erfindung weist der Leiterrahmen mindestens einen Chipanschlußbereich und mindestens einen Drahtanschlußbereich auf, wobei die LED in Form eines LED-Chips auf der Chipanschlußfläche montiert ist und über eine Drahtbrücke mit dem Drahtanschlußbereich elektrisch leitend verbunden ist. Chipanschlußbereich und Drahtanschlußbereich sind dabei so auf dem Leiterrahmen angeordet, daß die LED parallel zum Schmelzsteg geschalten ist.

Üblicherweise werden Leiterrahmen zur Kontaktierung und als Träger für LED-Chips verwendet. Mit Vorteil bildet dieser Leiterrahmen zugleich den Schmelzsteg, so daß bei der Erfindung nur eine geringe Anzahl von Einzelkomponenten benötigt wird. Der Strombegrenzungswiderstand kann auf dem Draht-Anschlußbereich in Form eines Dickschichtwiderstands in an sich bekannter Weise gebildet werden.

Vorzugsweise ist das Sicherungsbauelement einschließlich der LED zumindest teilweise von einer Umhüllung, vorzugsweise einer Formmasse umgeben. Dabei ist es zweckmäßig, daß die Umhüllung für das von der LED erzeugt Licht durchlässig ist. Für die Umhüllung von LED-Chips geeignete Formmassen sind bekannt und in hohem Maße optimiert, so daß eine Umhüllung des Sicherungsbauelements keinen besonderen technischen Aufwand mit sich bringt. Insbesondere eignen sich als Formmasse Reaktionsharze wie beispielsweise Epoxid-, Acryl- oder Siliconharze oder Mischungen hiervon. Durch eine solche Umhüllung entsteht ein kompaktes, gegen schädliche Einflüsse gut geschütztes Sicherungsbauelement.

Bevorzugt sind Seitenflächen der Umhüllung aufgerauht oder strukturiert, um die Lichtauskopplung zu erhöhen. Damit wird die Sichtbarkeit der optischen Anzeige im Defektfall weiter verbessert. Eine Aufrauhung kann mechanisch, beispielsweise durch Sandstrahlen oder chemisch, beispielsweise durch Ätzen, erfolgen.

Die Farbe des von der LED emittierten Lichts kann weiterhin zur Kennzeichnung der Sicherungsart, insbesondere des Maximalstroms dienen. Damit ist bei einem Ausfall des Sicherungsbauelements mit Vorteil sofort erkennbar, welcher Ersatz benötigt wird.

Weitere Merkmale, Vorteile und Zweckmäßigkeiten der Erfindung werden anhand von vier Ausführungsbeispielen in Verbindung mit den Figur 1 bis 4 erläutert.

Es zeigen
Figur 1 ein Schaltbild eines ersten Ausführungsbeispiels eines erfindungsgemäßen Sicherungsbauelements,
Figur 2 ein Schaltbild eines zweiten Ausführungsbeispiels eines erfindungsgemäßen Sicherungsbauelements,
Figur 3 eine schematische perspektivische Ansicht eines dritten Ausführungsbeispiels eines erfindungsgemäßen Sicherungsbauelements und
Figur 4 eine schematische perspektivische Ansicht eines vierten Ausführungsbeispiels eines erfindungsgemäßen Sicherungsbauelements.

Gleiche oder gleichwirkende Elemente sind in den Figuren mit denselben Bezugszeichen versehen.

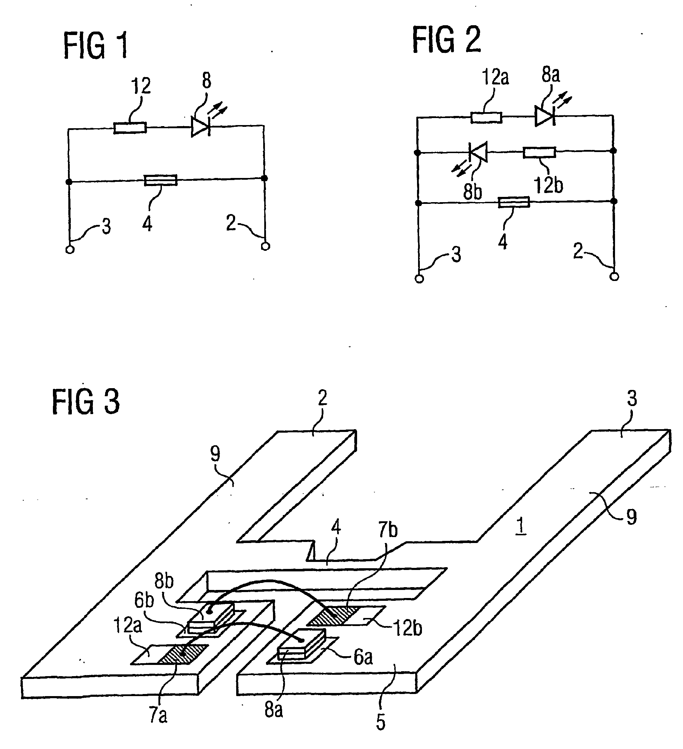

In Figur 1 ist das Schaltbild eines erfindungsgemäßen Sicherungsbauelements gezeigt. Die Schaltung weist einen ersten Anschluß 2 und einen zweiten Anschluß 3 auf, die über einen Schmelzsteg 4 miteinander elektrisch leitend verbunden sind. Parallel zu diesem Schmelzsteg 4 ist eine Serienschaltung aus einer LED 8 und einem Strombegrenzungswiderstand 12 geschaltet.

Solange der Schmelzsteg 4 unversehrt ist, wird die LED 8 von dem Schmelzsteg 4 kurzgeschlossen und die LED 8 leuchtet nicht. Nach einer Unterbrechung des Schmelzstegs 4 fällt zumindest ein Teil der Betriebsspannung zwischen den Anschlüssen 2 und 3 ab. Liegt dabei der Anschluß 3 auf einem höheren Potential als der Anschluß 2, so fließt ein Strom durch die LED 8 und die LED 8 leuchtet auf. Dies zeigt an, daß der Schmelzsteg 4 unterbrochen ist.

Der Strombegrenzungswiderstand 12 ist dabei so bemessen, daß auch bei einem Abfall der vollen Betriebsspannung, beispielsweise 12 V bei einer Kfz-Sicherung, zwischen den Anschlüssen 2 und 3 der fließende Strom auf den Nennstrom der LED 8 limitiert bleibt. Dieser Nennstrom liegt in der Regel zwischen 1 mA und 20 mA, der Strombegrenzungswiderstand 12 für eine 12V-Kfz-Sicherung entsprechend zwischen 12kΩ und 600Ω.

In Figur 2 ist das Schaltbild eines weiteren Ausführungsbeispiels der Erfindung gezeigt. Im Unterschied zu der vorigen Schaltung sind hier zwei Serienschaltungen mit je einer LED 8a,b und einem Strombegrenzungswiderstand 8a,b parallel zu dem Schmelzsteg 4 geschalten, wobei die Durchlaßrichtungen der LEDs 8a,b einander entgegengesetzt sind. Damit ist die Schaltung hinsichtlich der optischen Anzeige unabhängig von der Polung der zwischen den Anschlüssen 2 und 3 anliegenden Spannung. Das so gebildete Sicherungselement weist, wie herkömmliche Schmelzsicherungen, keine Polung auf, so daß vorteilhafterweise ein versehentlicher Einbau mit falscher Polung ausgeschlossen ist.

Das in Figur 3 dargestellte Ausführungsbeispiel der Erfindung weist einen jochförmigen Leiterrahmen 1 auf, wobei die Jochschenkel 9 die Anschlüsse 2 und 3 des Sicherungsbauelements bilden. Die Anschlüsse 2 und 3 sind über einen vom Jochbalken 5 separat ausgebildeten Schmelzsteg 4 elektrisch leitend verbunden. Das Material des Leiterrahmens und die Dicke und Breite des Schmelzstegs 4 sind entsprechend dem vorgesehenen Maximalstrom so gewählt, daß der Schmelzsteg 4 durchschmilzt, sobald er von einem größeren Strom als dem vorgesehenen Maximalstrom durchflossen wird.

Der Jochbalken 5 ist mittig durch eine Schlitzung unterbrochen, so daß über den Balken 5 selbst kein Strom zwischen den Anschlüssen 2 und 3 fließen kann. Auf beiden Seiten der Unterbrechung ist auf dem Leiterrahmen jeweils ein Chipanschlußbereich 6a,b und ein Drahtanschlußbereich 7a,b angeordnet, wobei die Drahtanschlußbereiche 7a,b als Dickschichtwiderstände 12a,b zur Strombegrenzung gebildet sind. Auf den Chipanschlußbereichen 6a,b ist jeweils ein LED-Chip 8a,b befestigt. Der LED-Chip 8a,b kann beispielsweise mittels eines leitfähigen Klebers aufgeklebt oder aufgelötet sein. Auf der Oberseite der LED-Chips 8a,b ist eine Kontaktmetallisierung ausgebildet, auf die eine Drahtverbindung aufgelötet ist. Die Drahtverbindung stellt jeweils den Kontakt zu dem auf der gegenüber liegenden Seite der Unterbrechung angeordneten Draht-anschlußbereich 7a,b her.

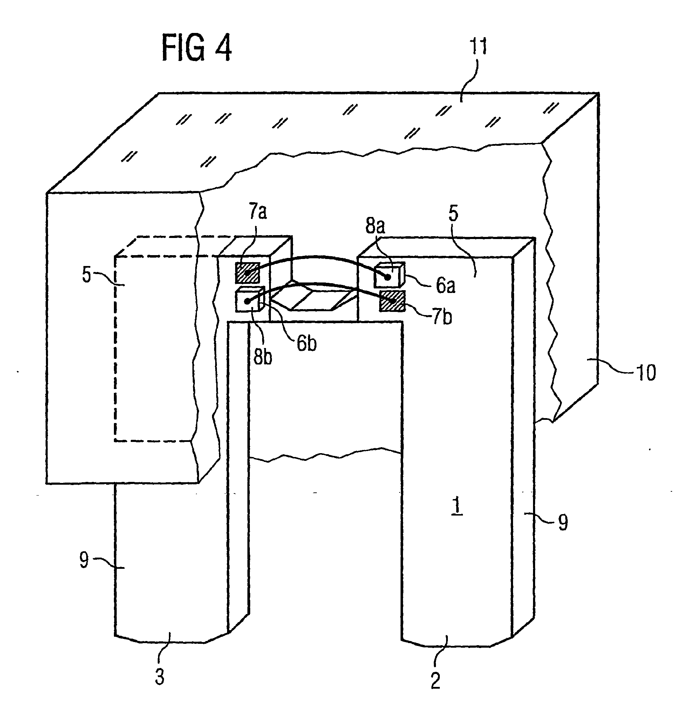

In Figur 4 ist ein weiteres Ausführungsbeispiel eines erfindungsgemäßen Sicherungsbauelements dargestellt. Das Sicherungsbauelement enthält wiederum einen jochförmigen Leiterrahmen 1, wobei die Jochschenkel 9 die Anschlüssen 2 und 3 bilden. Im Unterschied zu dem vorangehenden Ausführungsbeispiel ist der Schmelzsteg 4 mittig als Teil des Jochbalkens 5 ausgebildet. Auf beiden Seiten des Schmelzstegs 4 ist jeweils ein Chipanschlußbereich 6a,b mit einem darauf befestigten LED-Chip 8a,b sowie ein Drahtanschlußbereich 7a,b, gegebenenfalls wiederum mit Strombegrenzungswiderstand (nicht dargestellt), angeordnet. Über eine Drahtbrücke sind die LED-Chips 8a,b jeweils mit dem Drahtanschlußbereich 7a,b auf der gegenüberliegenden Seite des Schmelzstegs 4 verbunden und somit parallel zum Schmelzsteg 4 und antiparallel zueinander geschalten.

Der Leiterrahmen 1 ist weiterhin von einer vorzugsweise strahlungsdurchlässigen Umhüllung 10 umgeben. Bei der Zusammensetzung der Umhüllung und der Herstellung des Bauelements kann dabei mit Vorteil auf etablierte Techniken in der LED-Fertigung zurückgegriffen werden.

Zur Ausbildung der Umhüllung 10 wird der Leiterrahmen bevorzugt in eine strahlungsdurchlässige Formmasse eingebettet. Zur Einbettung des Leiterrahmens kann zum Beispiel ein Gießverfahren, ein Spritzgußverfahren, ein Spritzpreßgußverfahren oder ein Preßverfahren angewandt werden.

Als Formmasse eignen sich beispielsweise Reaktionsharze wie Epoxidharze, Acrylharze, Siliconharze oder Mischungen dieser Harze. Der Formmasse kann weiterhin ein Flammschutzmittel zugesetzt sein, um bei einem Durchschmelzen des Schmelzsteges die Gefahr einer Entzündung der Formmasse zu reduzieren. Gegebenenfalls ist es vorteil, die Umhüllung um den Schmelzsteg herum auszusparen, so daß bei einer Erwärmung des Schmelzsteges der Wärmeeintrag in die Umhüllung verringert und somit die Brandgefahr ebenfalls reduziert wird.

Weiterhin kann die Formmasse auch Leuchtstoffe enthalten, die von der LED erzeugte Strahlung einer ersten Wellenlänge zumindest teilweise in Strahlung einer zweiten Wellenlänge umwandeln. Damit kann der optische Eindruck mischfarbigen Lichts hervorgerufen werden. Aufgrund des so vergrößerten Farbraums ist eine detailliertere Klassifizierung des Bauelements anhand der Farbe des erzeugten Lichts möglich. Zudem ist eine Anpassung der Farbe an Gestaltungswünsche und Designvorgaben in weiten Grenzen möglich.

Hierzu kann als Zusatz für die Formmasse insbesondere ein anorganisches Leuchtstoffpigmentpulver mit Leuchtstoffen mit der allgemeinen Formel A₃B₅X₁₂:M verwendet werden. Dies sind bespielsweise mit Seltenen Erden, insbesondere Ce, dotierte Granate.

Als effiziente Leuchtstoffe haben sich Verbindungen erwiesen, die der Formel A'₃B'₅O₁₂:M' genügen (sofern sie nicht unter den üblichen Herstellungs- und Betriebsbedingungen instabil sind). Darin bezeichnet A' mindestens ein Element der Gruppe Y, Lu, Sc, La, Gd, Tb und Sm, B' mindestens ein Element der Gruppe Al, Ga und In und M' mindestens ein Element der Gruppe Ce und Pr, vorzugsweise Ce. Besonders effiziente Leuchtstoffe sind hierbei die Verbindungen YAG:Ce (Y₃Al₅O₁₂:Ce), TAG:Ce (Tb₃Al₅O₁₂:Ce), TbYAG:Ce ((TbₓY₁₋ₓ)₃Al₅O₁₂:Ce, 0≤x≤1), GdYAG:Ce ((GdₓY₁₋ₓ)₃Al₅O₁₂:Ce³⁺, 0≤x≤1) und GdTbYAG:Ce ((GdₓTb_{y}Y_{1-x-y})₃Al₅O₁₂:Ce³, 0≤x≤1, 0≤y≤1) sowie hierauf basierende Gemische. Dabei kann Al zumindest teilweise durch Ga oder In ersetzt sein. Die genannten Leuchtstoffe sind als Beispiel und nicht als Einschränkung der allgemeinen Formel A₃B₅X₁₂:M zu verstehen.

Weiter als Leuchtstoff geeignet sind die Verbindungen SrS:Ce³⁺,Na, SrS:Ce³⁺,Cl, SrS:CeCl₃, CaS:Ce³⁺ und SrSe:Ce³⁺. Darüber hinaus können auch Wirtsgitter auf Sulfid- und Oxysulfidbasis sowie Aluminate, Borate, Erdalkalisulfide, Thiogallate, oder Orthosilikate etc. mit entsprechend im kurzwelligen Bereich anregbaren Metallzentren oder metallorganischen Leuchtstoffsysteme verwendet werden. Weiterhin können lösliche und schwer lösliche organische Farbstoffe und Leuchtstoffmischungen eingesetzt werden.

Bei dem in Figur 4 gezeigten Ausführungsbeispiel ist weiterhin die Umhüllung 10 oberseitig mit einer Aufrauhung 11 versehen. Diese Aufrauhung stört die Totalreflexion des von den LED erzeugten Lichts an dieser Oberfläche, so daß die Lichtauskopplung erhöht und in Folge die Sichtbarkeit der optischen Anzeige verbessert wird.

Eine weitere Möglichkeit zur Erhöhung der Lichtauskopplung besteht darin, die Oberfläche der Umhüllung zumindest teilweise mit einer Strukturierung wie beispielsweise einer Mehrzahl von Rillen, Noppen, Prismen, Linsen oder dergleichen zu versehen. An der strukturierten Oberfläche wird ebenfalls die die Totalreflexion gestört und so die Sichtbarkeit der Anzeige verbessert.

Die Farbe des abgestrahlten Lichts kann zur Charakterisierung des Sicherungsbauelements, beispielsweise zur Kennzeichnung des Maximalstroms, herangezogen werden. Zum Beispiel können bei 10A-Kfz-Sicherungen rot emittierende LEDs und bei 6A-Kfz-Sicherungen gelbe LEDs verwendet werden. Damit wird dem Anwender bei einem Sicherungsdefekt sowohl der Defekt als auch die Art der benötigten Ersatzsicherung angezeigt.

Die Beschreibung der Erfindung anhand der gezeigten Ausführungsbeispiele ist selbstverständlich nicht als Beschränkung der Erfindung hierauf zu verstehen. Vielmehr sind der Formgebung des Sicherungsbauelements nahezu keine Grenzen gesetzt, so daß diese der jeweiligen Anwendung uneinschränkt angepaßt werden kann.

## Patentansprüche

1. Sicherungsbauelement mit einem ersten Anschluß (2), einem zweiten Anschluß (3), einem Schmelzsteg (4), der den ersten Anschluß (2) mit dem zweiten Anschluß (3) elektrisch leitend verbindet, und einer optischen Anzeige,
**dadurch gekennzeichnet, daß**
in dem Sicherungsbauelement für die optische Anzeige mindestens eine in Form eines LED-Chips ausgeführte LED (8) enthalten ist, die kathodenseitig mit dem ersten Anschluß (2) und anodenseitig mit dem zweiten Anschluß (3) verbunden ist.

2. Sicherungsbauelement nach Anspruch 1,
**dadurch gekennzeichnet, daß**
die LED (8) über einen Strombegrenzungswiderstand (12) mit einem der Anschlüsse (2,3) des Sicherungsbauelements verbunden ist.

3. Sicherungsbauelement nach Anspruch 1 oder 2,
**dadurch gekennzeichnet, daß**
die Anschlüsse (2, 3) und der Schmelzsteg (4) als Teile eines Leiterrahmens (1) gebildet sind und die LED (8) auf dem Leiterrahmen angeordnet ist.

4. Sicherungsbauelement nach Anspruch 3,
**dadurch gekennzeichnet, daß**
der Leiterrahmen (1) die Grundform eines Jochs aufweist, wobei die Jochschenkel (9) die Anschlüsse (2,3) bilden.

5. Sicherungsbauelement nach Anspruch 4,
**dadurch gekennzeichnet, daß**
der Schmelzsteg (4) parallel zu einen Jochbalken (5) oder als Teil eines Jochbalkens (5) ausgebildet ist.

6. Sicherungsbauelement nach einem der Ansprüche 3 bis 5,
**dadurch gekennzeichnet, daß**
auf dem Leiterrahmen (1) mindestens ein Chipanschlußbereich (6) und mindestens ein Draht-Anschlußbereich (7) ausgebildet ist, wobei der LED-Chip (8) auf dem Chipanschlußbereich (6) aufgebracht und mit dem Drahtanschlußbereich (7) elektrisch leitend verbunden ist.

7. Sicherungsbauelement nach einem der Ansprüche 1 bis 6,
**dadurch gekennzeichnet, daß**
das Sicherungsbauelement zwei LEDs (8a,b) enthält, wobei die erste LED (8a) kathodenseitig mit dem ersten Anschluß (2) und anodenseitig mit dem zweiten Anschluß (3) und die zweite LED (8b) kathodenseitig mit dem zweiten Anschluß (2) und anodenseitig mit dem ersten Anschluß (3) verbunden ist.

8. Sicherungsbauelement nach einem der Ansprüche 1 bis 7,
**dadurch gekennzeichnet, daß**
das Sicherungsbauelement zumindest teilweise von einer Formmasse (10) umhüllt ist.

9. Sicherungsbauelement nach Anspruch 8,
**dadurch gekennzeichnet, daß**
das Sicherungsbauelement mit der Formmasse (10) vermittels eines Gießverfahrens, eines Spritzverfahrens, eines Spritzgußverfahrens, eines Spritzpreßgußverfahren oder eines Preßverfahrens umhüllt ist.

10. Sicherungsbauelement nach Anspruch 8 oder 9,
**dadurch gekennzeichnet, daß**
die Formmasse (10) für Strahlung, die von der LED (8) erzeugt wird, durchlässig ist.

11. Sicherungsbauelement nach einem der Ansprüche 8 bis 10,
**dadurch gekennzeichnet, daß**
die Formmasse (10) ein Reaktionsharz, insbesondere ein Epoxidharz, ein Acrylharz, ein Siliconharz oder eine Mischung dieser Harze enthält.

12. Sicherungsbauelement nach einem der Ansprüche 8 bis 11,
**dadurch gekennzeichnet, daß**
die Formmasse (10) ein Flammschutzmittel enthält.

13. Sicherungsbauelement nach einem der Ansprüche 8 bis 12,
**dadurch gekennzeichnet, daß**
die Formmasse (10) mindestens einen Leuchtstoff enthält, der von der LED (8) emittierte Strahlung einer ersten Wellenlänge zumindest teilweise in Strahlung einer zweiten Wellenlänge umwandelt.

14. Sicherungsbauelement nach einem der Ansprüche 8 bis 13,
**dadurch gekennzeichnet, daß**
die Oberfläche des Formmasse (10) zumindest teilweise aufgerauht oder zumindest teilweise strukturiert ist.

15. Sicherungsbauelement nach einem der Ansprüche 1 bis 14,
**dadurch gekennzeichnet, daß**
die Farbe des mittels der LED (8) erzeugten Lichts den Sicherungstyp optisch anzeigt.

## Claims

1. Fuse component with a first terminal (2), a second terminal (3), a fusible link (4), which connects the first terminal (2) to the second terminal (3) in an electrically conducting manner, and an optical indicator, **characterized in that** the fuse component includes for the optical indicator at least one LED (8) realized in the form of an LED chip, which is connected on the cathode side to the first terminal (2) and on the anode side to the second terminal (3).

2. Fuse component according to Claim 1, **characterized in that** the LED (8) is connected to one of the terminals (2, 3) of the fuse component by means of a current-limiting resistor (12).

3. Fuse component according to Claim 1 or 2, **characterized in that** the terminals (2, 3) and the fusible link (4) are formed as parts of a leadframe (1) and the LED (8) is arranged on the leadframe.

4. Fuse component according to Claim 3, **characterized in that** the leadframe (1) has the basic form of a yoke, the yoke limbs (9) forming the terminals (2, 3).

5. Fuse component according to Claim 4, **characterized in that** the fusible link (4) is formed parallel to a yoke bar (5) or as part of a yoke bar (5).

6. Fuse component according to one of Claims 3 to 5, **characterized in that** formed on the leadframe (1) is at least one chip connecting pad (6) and at least one wire connecting pad (7), the LED chip (8) being mounted on the chip connecting pad (6) and connected in an electrically conducting manner to the wire connecting pad (7).

7. Fuse component according to one of Claims 1 to 6, **characterized in that** the fuse component includes two LEDs (8a,b), the first LED (8a) being connected on the cathode side to the first terminal (2) and on the anode side to the second terminal (3) and the second LED (8b) being connected on the cathode side to the second terminal (3) and on the anode side to the first terminal (2).

8. Fuse component according to one of Claims 1 to 7, **characterized in that** the fuse component is at least partly enclosed by a moulding composition (10).

9. Fuse component according to Claim 8, **characterized in that** the fuse component is enclosed with the moulding composition (10) by means of a casting method, a spraying method, an injection moulding method, a transfer moulding method or a compression moulding method.

10. Fuse component according to Claim 8 or 9, **characterized in that** the moulding composition (10) is permeable to radiation that is generated by the LED (8).

11. Fuse component according to one of Claims 8 to 10, **characterized in that** the moulding composition (10) contains a reaction resin, in particular an epoxy resin, an acrylic resin, a silicone resin or a mixture of these resins.

12. Fuse component according to one of Claims 8 to 11, **characterized in that** the moulding composition (10) contains a flame retardant.

13. Fuse component according to one of Claims 8 to 12, **characterized in that** the moulding composition (10) contains at least one fluorescent material which converts radiation emitted by the LED (8) of a first wavelength at least partly into radiation of a second wavelength.

14. Fuse component according to one of Claims 8 to 13, **characterized in that** the surface of the moulding composition (10) is at least partly roughened or at least partly structured.

15. Fuse component according to one of Claims 1 to 14, **characterized in that** the colour of the light generated by means of the LED (8) visually indicates the fuse type.

## Revendications

1. Composant fusible comprenant une première borne (2), une deuxième borne (3), une barrette (4) fusible qui relie d'une manière conductrice de l'électricité la première borne (2) à la deuxième borne (3), **caractérisé en ce que**, dans le composant fusible, est contenue pour l'indication optique au moins une LED (8) réalisée sous la forme d'une puce LED, qui est reliée du côté de la cathode à la première borne (2) et du côté de l'anode à la deuxième borne (3).

2. Composant fusible suivant la revendication 1, **caractérisé en ce que** la LED (8) est reliée à l'une des bornes (2, 3) du composant fusible par une résistance (12) de limitation du courant.

3. Composant fusible suivant la revendication 1 ou 2, **caractérisé en ce que** les bornes (2, 3) et la barrette (4) fusible sont formées en tant que parties d'un cadre (1) conducteur et la LED (8) est disposée sur le cadre conducteur.

4. Composant fusible suivant la revendication 3, **caractérisé en ce que** le cadre (1) conducteur a la forme d'une culasse, les branches (9) de la culasse formant les bornes (2, 3) .

5. Composant fusible suivant la revendication 4, **caractérisé en ce que** la barrette (4) fusible est parallèle à une âme (5) de la culasse ou est constituée sous la forme d'une partie d'une âme (5) de culasse.

6. Composant fusible suivant l'une des revendications 3 à 5, **caractérisé en ce que** sur le cadre (1) conducteur est constituée au moins une zone (6) de borne de puce et au moins une zone (7) de borne de fil, la puce (8) LED étant déposée sur la zone (6) de borne de puce et étant reliée d'une manière conductrice de l'électricité à la zone (7) de borne de fil.

7. Composant fusible suivant l'une des revendications 1 à 6, **caractérisé en ce que** le composant fusible comporte deux LED (8a, b), la première LED (8a) étant reliée du côté de la cathode à la première borne (2) et du côté de l'anode à la deuxième borne (3) et la deuxième LED (8b) étant reliée du côté de la cathode à la deuxième borne (3) et du côté de l'anode à la première borne (2).

8. Composant fusible suivant l'une des revendications 1 à 7, **caractérisé en ce que** le composant fusible est enrobé au moins en partie d'une composition (10) à mouler.

9. Composant fusible suivant la revendication 8, **caractérisé en ce que** le composant fusible est enrobé de la composition (10) à mouler au moyen d'un procédé de coulée, d'un procédé de pulvérisation, d'un procédé de moulage par injection, d'un procédé de moulage par transfert ou d'un procédé de moulage par compression.

10. Composant fusible suivant la revendication 8 ou 9, **caractérisé en ce que** la composition (10) à mouler est transparente à du rayonnement qui est produit par la LED (8).

11. Composant fusible suivant l'une des revendications 8 à 10, **caractérisé en ce que** la composition (10) à mouler contient une résine de réaction, notamment une résine époxy, une résine acrylique, une résine de silicone ou un mélange de ces résines.

12. Composant fusible suivant l'une des revendications 8 à 11, **caractérisé en ce que** la composition (10) à mouler contient un agent ignifuge.

13. Composant fusible suivant l'une des revendications 8 à 12, **caractérisé en ce que** la composition (10) à mouler comprend au moins une substance luminescente qui transforme du rayonnement émis par la LED (8) d'une première longueur d'onde au moins en partie en du rayonnement d'une deuxième longueur d'onde.

14. Composant fusible suivant l'une des revendications 8 à 13, **caractérisé en ce que** la surface de la composition (10) à mouler est rendue rugueuse au moins en partie ou est structurée au moins en partie.

15. Composant fusible suivant l'une des revendications 8 à 14, **caractérisé en ce que** la couleur de la lumière produite au moyen de la LED (8) indique optiquement le type de fusible.
